# EUROPEAN PATENT APPLICATION

(11) **EP 4 636 985 A1**
(43) Date of publication of application: **22.10.2025**
(21) Application number: 25154327.8
(22) Date of filing: 28.01.2025
(51) Int. Cl.: H02J 7/00, H02J 50/00, H02J 50/10, H05K 7/20

(54) **WIRELESS CHARGING DEVICE AND VEHICLE**

(30) Priority: 19.04.2024 CN 202410476398
(71) Applicant: Xuancheng Luxshare Precision Industry Co., Ltd, Xuancheng City, Anhui (CN)
(72) Inventor: WANG, Linwei, Xuancheng City, Anhui Province (CN); BAI, Xueping, Xuancheng City, Anhui Province (CN); DAI, Weisheng, Xuancheng City, Anhui Province (CN); PI, Xiubo, Xuancheng City, Anhui Province (CN); CAO, Yangqiu, Xuancheng City, Anhui Province (CN)
(74) Representative: Michalski Hüttermann & Partner Patentanwälte mbB

(57) **Abstract**

A wireless charging device includes a housing, a wireless charging module and a fan module. The housing defines a receiving cavity. The wireless charging module is disposed in the receiving cavity. The wireless charging module includes a first circuit board and a first connector provided on the first circuit board. The fan module is disposed in the receiving cavity. The fan module includes a fan and a second circuit board disposed on the fan. The first connector is in elastic contact with the second circuit board. As a result, noise pollution caused by the vibration of the fan when it is turned on can be reduced. A vehicle having the wireless charging device is also disclosed.

## Description

### CROSS-REFERENCE TO RELATED APPLICATION

The present invention claims priority of a Chinese Patent Application No. 202410476398.X, filed on April 19, 2024 and titled "WIRELESS CHARGING DEVICE AND VEHICLE".

### TECHNICAL FIELD

The present invention relates to the field of wireless charging, and in particular, to a wireless charging device and a vehicle.

### BACKGROUND

Due to market demand, the wireless charging power of electronic products such as mobile phones and PADs is gradually increasing. When the charging power reaches a certain level, the corresponding wireless charging base needs to add a fan for active cooling. The added fan needs to draw power from the wireless charging product. One way is for the fan to lead out an electronic wires and a connector. Power is drawn from a mating connector on a motherboard. However, the fan requires additional electronic wire and connector. Besides, manual wiring is required when assembling the fan, which results in low production efficiency. Another way is to design a pin on a bottom of the fan and solder it to the motherboard. When the fan works in this way, it is easy to resonate with the motherboard and increase the noise, which is very detrimental to the home environment or new energy vehicles that have strict noise requirements.

Therefore, it is necessary to provide a new wireless charging device and vehicle to solve the above problems.

### SUMMARY

An object of the present invention is to provide a wireless charging device and a vehicle having the wireless charging device to reduce noise caused by fan vibration and reduce production costs.

In order to achieve the above object, the following technical solution is suggested: a wireless charging device, including: a housing defining a receiving cavity; a wireless charging module disposed in the receiving cavity, the wireless charging module including a first circuit board and a first connector provided on the first circuit board; and a fan module disposed in the receiving cavity, the fan module including a fan and a second circuit board provided on the fan; the first connector is in elastic contact with the second circuit board.

The first connector may include an insulating body and a plurality of conductive terminals fixed to the insulating body; the conductive terminal may include a fixing portion and a cantilever portion extending and bent from the fixing portion; the cantilever portion may protrude beyond the insulating body; the fan module may include a conductive portion connected to the second circuit board; the cantilever portion of the conductive terminal may be in elastic contact with the conductive portion.

The insulating body may define a plurality of receiving slots and a plurality of step portions corresponding to the plurality of receiving slots; corresponding to each receiving slot, two step portions may be provided and may extend into the receiving slot; the cantilever portion may include a blocking portion abutting against the two step portions.

The cantilever portion may be provided with a protruding contact portion which is in surface-to-surface contact with the conductive portion.

The fan module further may include a fan housing in which the second circuit board is disposed; the fan housing may define a through hole; the conductive portion may pass through the through hole to be connected to the second circuit board.

The housing may include a first housing and a second housing; the first housing and the second housing may be snap-fitted to form the receiving cavity; the fan may be fixed to an inner wall of the first housing; the first circuit board is fixed to an inner wall of the second housing.

An elastic member may be further provided between the fan and the inner wall of the first housing.

The wireless charging device may further include a shielding plate provided in the receiving cavity; the shielding plate may be disposed between the fan and the first circuit board; the first connector may pass through the shielding plate to be in elastic contact with the conductive portion of the second circuit board.

The wireless charging device may further include a shielding circuit board and a power transmitting coil; a recessed portion may be provided on a side of the second housing away from the receiving cavity; the power transmitting coil may be disposed in the recessed portion; the shielding circuit board may cover the power transmitting coil.

The wireless charging device may further include an air duct provided in the first housing; an air inlet of the air duct may be arranged corresponding to the fan module, and an air outlet of the air duct may be located next to the shielding circuit board.

The first circuit board and the second circuit board may be detachably assembled together.

The elastic member may be configured to absorb vibration generated by the fan, so that the vibration will not be directly transmitted to the first housing.

The first housing may include a first bottom wall, the first bottom wall may be provided with a protruding portion protruding outward from the first bottom wall toward a side away from the receiving cavity, the protruding portion may include a second bottom wall, the second bottom wall may define a plurality of air inlet holes, the fan may be disposed facing the plurality of air inlet holes, and the elastic member may be disposed around the plurality of air inlet holes.

The second bottom wall may be further provided with a reinforcing rib which may be in a semi-ring shape, the reinforcing rib may be disposed around the plurality of air inlet holes, the elastic member may be in a semi-ring shape, and the elastic member and the reinforcing rib may be arranged concentrically.

In order to achieve the above object, the following technical solution is suggested: a vehicle, including: a control module and the aforementioned wireless charging device; wherein the first circuit board may be further provided with a third connector, and the control module of the vehicle may be electrically connected to the third connector.

The invention is defined by the features of the independent claims.

Compared with the existing technology, the beneficial effects of the present invention are as follows: the invention discloses a wireless charging device including a housing, a wireless charging module and a fan module. The housing defines a receiving cavity. The wireless charging module is disposed in the receiving cavity. The wireless charging module includes a first circuit board and a first connector provided on the first circuit board. The fan module is disposed in the receiving cavity. The fan module includes a fan and a second circuit board provided on the fan. Through the elastic contact between the first connector and the second circuit board, the vibration generated by the fan when it is turned on can be reduced, thereby reducing the noise, and at the same time, automated assembly can be realized.

### BRIEF DESCRIPTION OF DRAWINGS

FIG. 1 is a perspective schematic view of a wireless charging module in accordance with an embodiment of the present invention;
FIG. 2 is a perspective view of FIG. 1 from another angle;
FIG. 3 is a perspective exploded schematic view of FIG. 1;
FIG. 4 is an exploded perspective view of FIG. 3 from another angle;
FIG. 5 is a schematic perspective view of a first housing, a fan module and an air duct in accordance with an embodiment of the present invention;
FIG. 6 is a partially enlarged schematic view of part A in FIG. 5;
FIG. 7 is a schematic perspective view of the fan module and a first connector in an elastic contact state in accordance with an embodiment of the present invention;
FIG. 8 is a perspective exploded schematic view of FIG. 7;
FIG. 9 is a perspective view of the first connector in accordance with an embodiment of the present invention;
FIG. 10 is a perspective view of the first housing in accordance with an embodiment of the present invention; and
FIG. 11 is a perspective exploded schematic view of the fan module, an elastic member and the first housing in accordance with an embodiment of the present invention.

### DETAILED DESCRIPTION

Exemplary embodiments of the present invention will be described in detail here, examples of which are shown in drawings. When referring to the drawings below, unless otherwise indicated, same numerals in different drawings represent the same or similar elements. The examples described in the following exemplary embodiments do not represent all embodiments consistent with the present invention. Rather, they are merely examples of devices consistent with the present invention as detailed in the appended claims.

The terminology used in the present invention is only for the purpose of describing particular embodiments, and is not intended to limit the present invention. The singular forms "a", "said", and "the" used in the present invention and the appended claims are also intended to include plural forms unless the context clearly indicates other meanings.

It should be understood that the terms "first", "second" and similar words used in the specification and claims of the present invention do not represent any order, quantity or importance, but are only used to distinguish different components. Similarly, "an" or "a" and other similar words do not mean a quantity limit, but mean that there is at least one; "multiple" or "a plurality of" means two or more than two. Unless otherwise noted, "front", "rear", "lower" and/or "upper" and similar words are for ease of description only and are not limited to one location or one spatial orientation. Similar words such as "include" or "comprise" mean that elements or objects appear before "include" or "comprise" cover elements or objects listed after "include" or "comprise" and their equivalents, and do not exclude other elements or objects. The term "a plurality of" mentioned in the present invention includes two or more.

Hereinafter, some embodiments of the present invention will be described in detail with reference to the accompanying drawings.

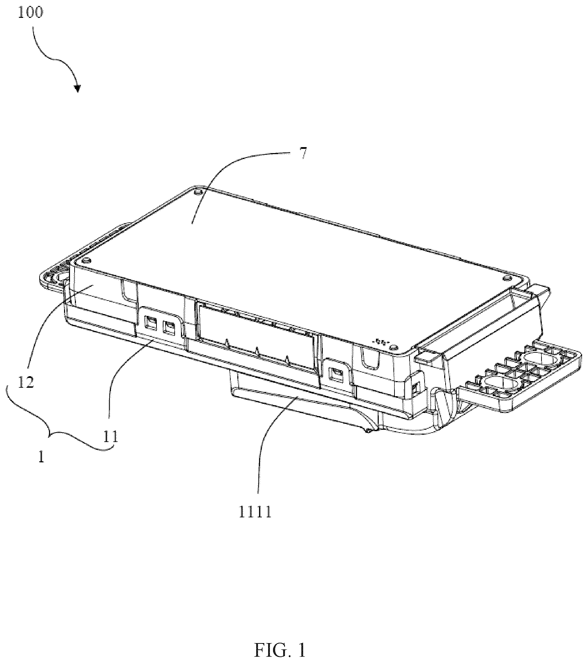

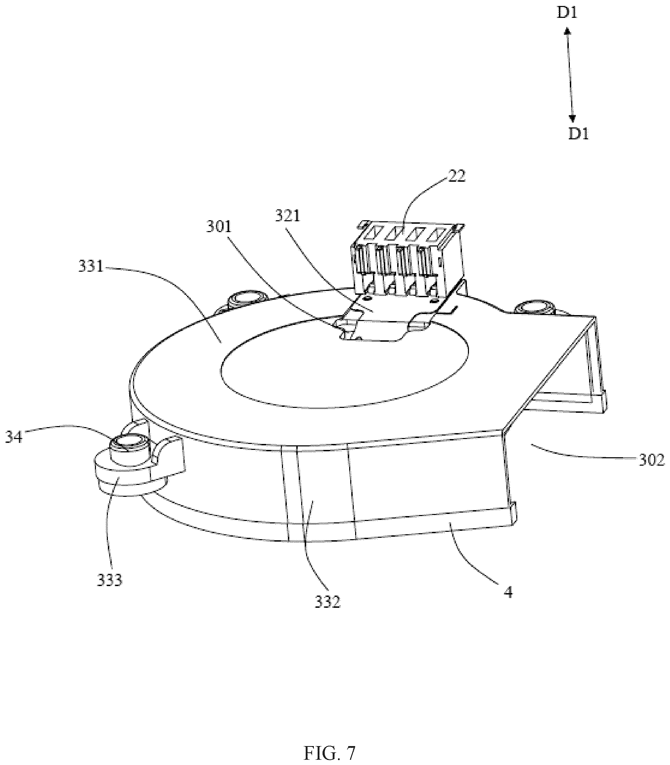

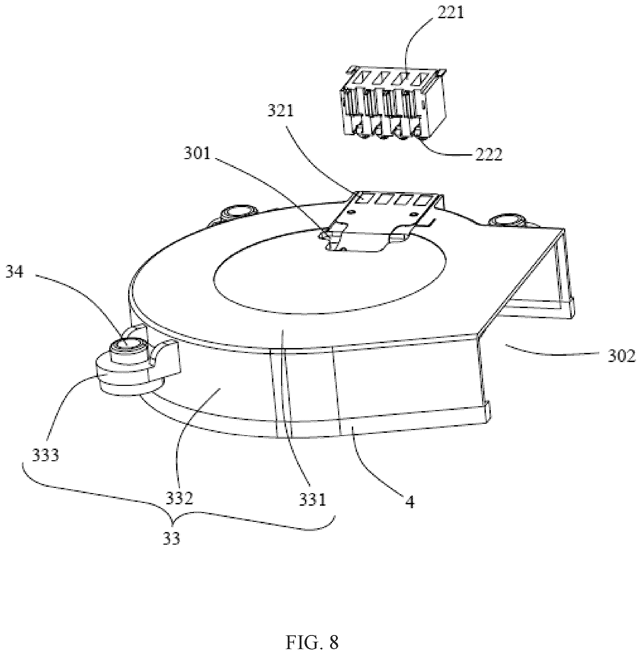

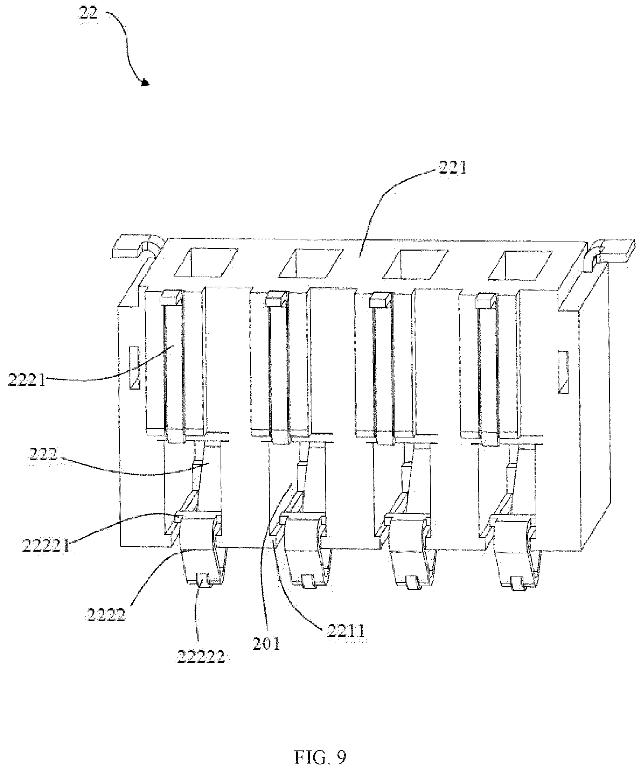

Referring to FIG. 1 to FIG. 11, the present invention discloses a wireless charging device 100 including a housing 1, a wireless charging module 2 and a fan module 3.

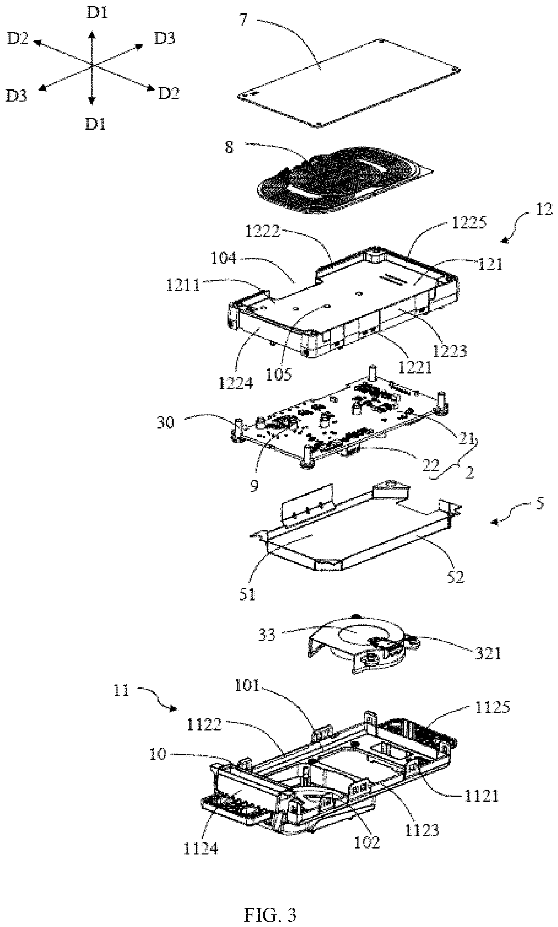

For ease of explanation, A first direction D1-D1 shown in FIG. 3 is defined as a height direction of the wireless charging device 100; a second direction D2-D2 is defined as a front-back direction of the wireless charging device 100; and a third direction D3-D3 is defined as a left-right direction of the wireless charging device 100. Each two of the first direction D1-D1, the second direction D2-D2 and the third direction D3-D3 are perpendicular to each other.

Referring to FIG. 3 to FIG. 6, the housing 1 defines a receiving cavity 101 in which the wireless charging module 2 is disposed. The wireless charging module 2 includes a first circuit board 21 and a first connector 22 provided on the first circuit board 21. The fan module 3 is disposed in the receiving cavity 101. The fan module 3 includes a fan 31 and a second circuit board 32 provided on the fan 31. The first connector 22 is in elastic contact with the second circuit board 32. In other words, the first circuit board 21 and the second circuit board 32 are detachably assembled together. In this way, the vibration generated when the fan 31 is turned on can be reduced, thereby reducing noise. Compared with manual wiring, the elastic connection can also realize automated assembly, thereby saving assembly time compared with manual assembly.

Referring to FIG. 3 to FIG. 6, the first connector 22 and the second circuit board 32 are arranged face to face in the first direction D1-D1. The first connector 22 is disposed on a bottom of the first circuit board 21, and the second circuit board 32 is disposed on a top of the fan 31, thereby facilitating direct electrical connection between the first connector 22 and the second circuit board 32. The two not only save the cables required for connection, but also improve the space utilization, making the overall structure of the wireless charging device 100 lighter and thinner.

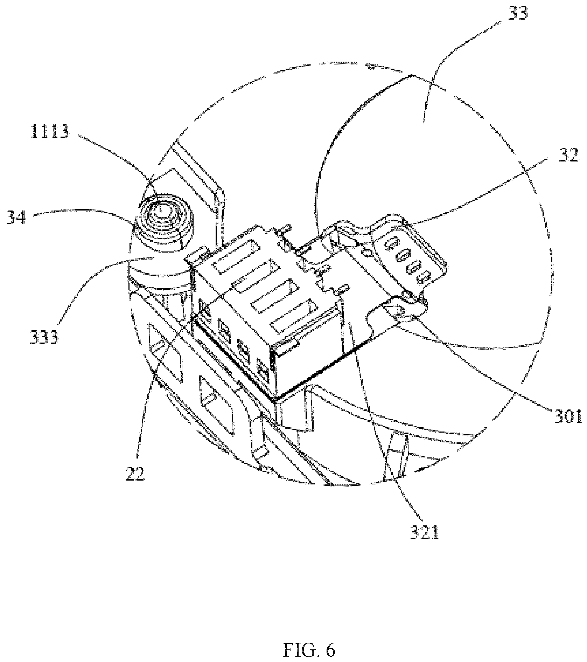

Referring to FIG. 6 to FIG. 9, the first connector 22 includes an insulating body 221 and a plurality of conductive terminals 222 fixed to the insulating body 221. The conductive terminal 222 includes a fixing portion 2221 and a cantilever portion 2222 extending and bent from the fixing portion 2221. The cantilever portion 2222 protrudes beyond the insulating body 221. Specifically, the insulating body 221 defines a plurality of receiving slots 201 and a plurality of step portions 2211 corresponding to the plurality of receiving slots 201. Corresponding to each receiving slot 201, two step portions 2211 are provided and extend sidewards or sidewardly into the receiving slot 201. The cantilever portion 2222 is provided with a blocking portion 22221. The two step portions 2211 corresponding to each receiving slot 201 are configured to abut against the blocking portion 22221 so as to prevent the blocking portion 22221 of the cantilever portion 2222 from moving toward an outside of the insulating body 221. The receiving slot 201 faces the second circuit board 32. The cantilever portion 2222 elastically expands and contracts along the first direction D1-D1. Preferably, the blocking portion 22221 is disposed at a free end of the cantilever portion 2222. At least part of the hook-shaped cantilever portion 2222 protrudes beyond the insulating body 221. The blocking portion 22221 is located in the receiving slot 201. When the cantilever portion 2222 comes into contact the second circuit board 32, the cantilever portion 2222 is pressed by the second circuit board 32 and moves into the receiving slot 201 to store energy. When the cantilever portion 2222 is separated from the second circuit board 32, the cantilever portion 2222 releases the stored energy and moves toward the outside of the insulating body 221 along the first direction D1-D1.

Referring to FIG. 6 to FIG. 9, the fan module 3 includes a conductive portion 321 connected to the second circuit board 32. The cantilever portion 2222 of the conductive terminal 222 is in elastic contact with the conductive portion 321. The conductive portion 321 and the cantilever portion 2222 are arranged correspondingly up and down along the first direction D1-D1, so that the conductive portion 321 and the cantilever portion 2222 can be directly electrically connected after assembly, thereby improving the conductive performance of the first connector 22 and the second circuit board 32. The cantilever portion 2222 is provided with a contact portion 22222 protruding from the cantilever portion 2222. Preferably, the cantilever portion 2222 is generally hook-shaped. The contact portion 22222 is provided at a hook of the cantilever portion 2222. The contact portion 22222 is in an arc shape. When the cantilever portion 2222 comes into contact with the conductive portion 321, surface-to-surface contact is formed between the contact portion 22222 and the conductive portion 321, which avoids stress concentration causing scratches on the conductive portion 321 and causing circuit breakage.

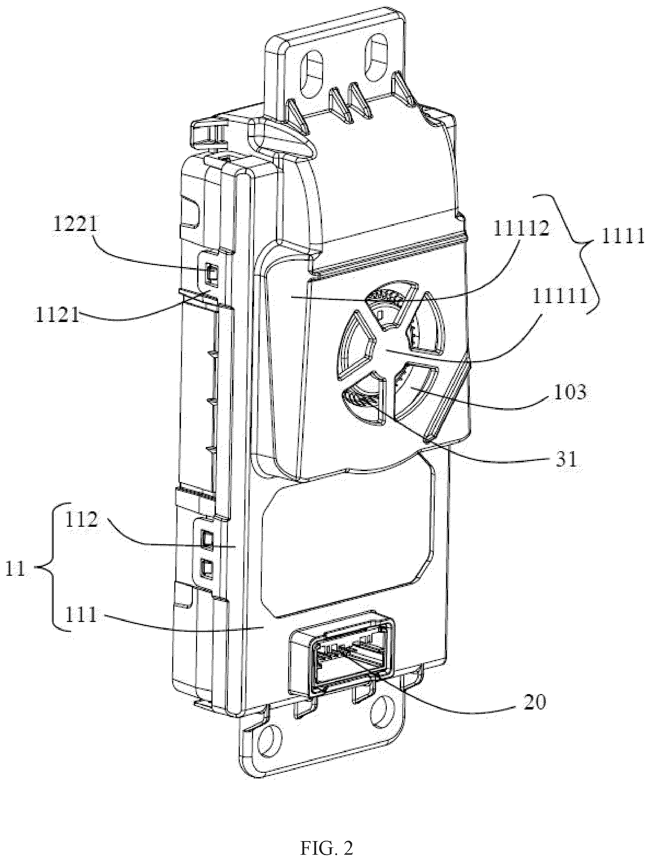

Referring to FIG. 2 to FIG. 3, the housing 1 includes a first housing 11 and a second housing 12. The first housing 11 and the second housing 12 are snap-fitted to form the receiving cavity 101. The fan 31 is fixed to an inner wall of the first housing 11. The first circuit board 21 is fixed to an inner wall of the second housing 12. An elastic member 4 is further provided and disposed between the fan 31 and the inner wall of the first housing 11. The elastic member 4 is configured to absorb the vibration generated when the fan 31 is turned on, so that the vibration will not be directly transmitted to the first housing 11, thereby reducing noise.

Specifically, the first housing 11 includes a first bottom wall 111 and a first side wall 112 extending upwardly from an edge of the first bottom wall 111 along the first direction D1-D1. The second housing 12 includes a first top wall 121 and a second side wall 122 extending downwardly from an edge of the first top wall 121 along the first direction D1-D1. A plurality of locking portions 1121 are provided on the first side wall 112. A plurality of buckles 1221 are provided on the second side wall 122. The locking portions 1121 are snap-connected to the buckles 1221 so that the first side wall 112 and the second side wall 122 can be snap-connected. In other embodiments, the first side wall 112 and the second side wall 122 may also be fixed by gluing or screwing, which is not limited in the present invention.

The first bottom wall 111 is provided with a protruding portion 1111. The protruding portion 1111 protrudes outward from the first bottom wall 111 toward a side away from the receiving cavity 101. The protruding portion 1111 includes a second bottom wall 11111 and a connecting wall 11112. One side of the connecting wall 11112 is connected to the second bottom wall 11111, and the other side of the connecting wall 11112 is connected to the first bottom wall 111. The second bottom wall 11111 and the connecting wall 11112 together form an accommodating cavity 102 in communication with the receiving cavity 101. The fan 31 and the elastic member 4 are both arranged in the accommodating cavity 102. In this embodiment, the protruding portion 1111 and the first bottom wall 111 are integrally formed, which can replace part of the housing of the fan 31, thereby saving space and reducing costs.

Specifically, the second bottom wall 11111 defines a plurality of air inlet holes 103. The fan 31 is disposed facing the air inlet holes 103. The elastic member 4 is disposed around a periphery of the air inlet holes 103. The fan 31 is in elastic contact with the elastic member 4.

Specifically, the fan module 3 further includes a fan housing 33. The second circuit board 32 is disposed inside the fan housing 33. The fan housing 33 defines a through hole 301. The conductive portion 321 passes through the through hole 301 and is connected to the second circuit board 32. The fan housing 33 and the elastic member 4 are disposed opposite to each other in the first direction D1-D1. The fan housing 33 is in elastic contact with the elastic member 4. The second bottom wall 11111 is further provided with a reinforcing rib 1112 which is in a semi-ring shape. In this embodiment, the reinforcing rib 1112 is provided and disposed around the periphery of the air inlet holes 103. The elastic member 4 is in a semi-ring shape, and the elastic member 4 and the reinforcing rib 1112 are arranged concentrically. By arranging the elastic member 4 around a periphery of the reinforcing rib 1112, the elastic member 4 is positioned on the second bottom wall 11111, thereby preventing the elastic member 4 from being displaced after the fan housing 33 comes into contact with the elastic member 4.

The fan housing 33 includes a base portion 331 and an annular portion 332 vertically extending from an edge of the base portion 331. The fan 31 is provided at a bottom of the base portion 331. The second circuit board 32 is disposed on a top of the base portion 331. The fan 31 is electrically connected to the second circuit board 32. The base portion 331 is circular. The annular portion 332 is in a semi-annular shape, and a diameter of the annular portion 332 is the same as a diameter of the elastic member 4. The annular portion 332 has a notch 302. The elastic member 4 elastically contacts a bottom of the annular portion 332 along the first direction D1-D1. Preferably, the elastic member 4 is a rubber pad. In other embodiments, the elastic member 4 can also be a spring, which is not limited here. As a result, the elastic member 4 can avoid direct contact between the fan housing 33 and the second bottom wall 11111. When the fan 31 is turned on, the elastic member 4 can absorb the vibration generated by the fan 31, thereby reducing noise.

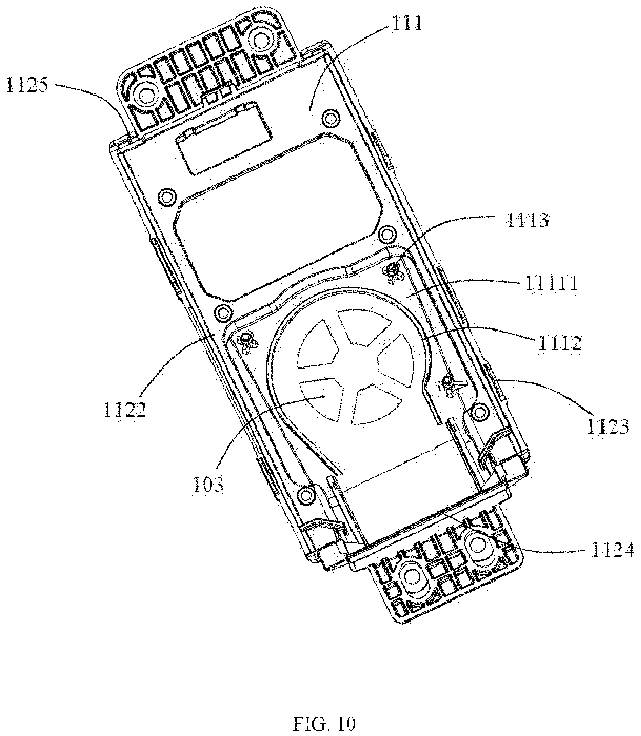

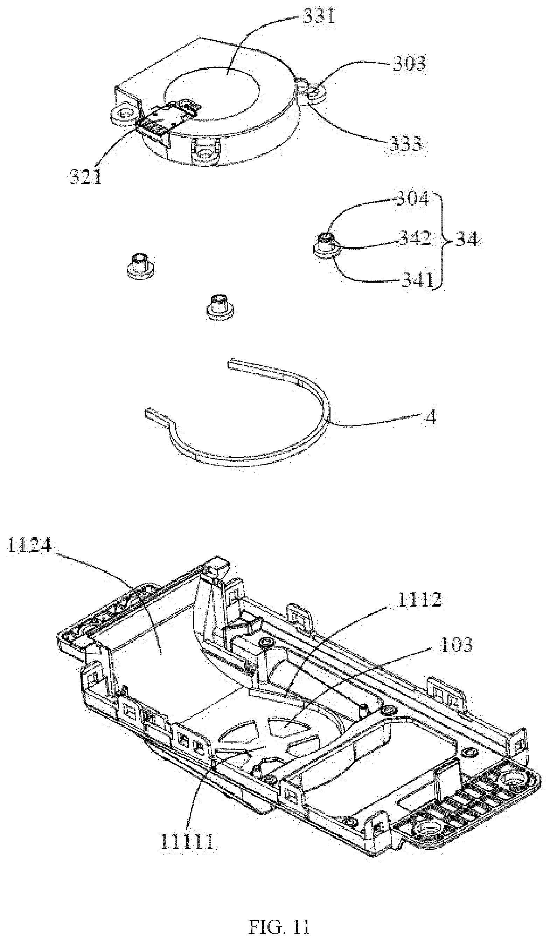

Referring to FIG. 10 and FIG. 11, a plurality of positioning portions 333 are provided on an outer periphery of the annular portion 332 of the fan housing 33. The positioning portion 333 defines a positioning hole 303. A plurality of positioning posts 1113 are provided on the second bottom wall 11111. The positioning post 1113 is disposed between the connecting wall 11112 and the reinforcing rib 1112. The positioning portion 333 and the positioning post 1113 are fixedly connected through a soft fastener 34. The soft fastener 34 defines a connection hole 304. A first connection portion 341 and a second connection portion 342 are provided outside the connection hole 304. An outer diameter of the first connection portion 341 is larger than an outer diameter of the second connection portion 342. Preferably, the soft fastener 34 is made of rubber material. In assembly, firstly, the second connection portion 342 is passed through the positioning hole 303 from a bottom of the positioning portion 333, so that the second connection portion 342 is engaged with the positioning portion 333. Then, the first connection portion 341 is sleeved on the positioning post 1113, so that the first connection portion 341 is connected to the positioning post 1113. As a result, while the fan housing 33 can be fixedly connected to the second bottom wall 11111, the soft fastener 34 can further absorb the vibration generated by the fan housing 33 when the fan 31 is turned on, thereby reducing noise.

Referring to FIG. 2 and FIG. 3, the wireless charging device 100 further includes a shielding plate 5 disposed in the receiving cavity 101. The shielding plate 5 is disposed between the fan 31 and the first circuit board 21. The first connector 22 passes through the shielding plate 5 and is in elastic contact with the conductive portion 321 of the second circuit board 32. In this embodiment, the shielding plate 5 is made of metal. The shielding plate 5 is configured to shield the electromagnetic interference generated by the first circuit board 21. The shielding plate 5 is generally rectangular. The shielding plate 5 includes a bottom plate 51 and a plurality of side plates 52 extending vertically and upwardly from an edge of the bottom plate 51. The bottom plate 51 defines a first through hole 501. The first connector 22 passes through the first through hole 501 and is in elastic contact with the conductive portion 321 of the second circuit board 32. The side plates 52 define a plurality of first mounting holes 502 disposed at four top corners. The first circuit board 21 defines a plurality of second mounting holes disposed at four top corners. Metal screws 30 are provided and pass through the first mounting holes 502 and the second mounting holes in sequence along the first direction D1-D1 to fix the shielding plate 5 and the first circuit board 21 to a bottom of the second housing 12. As a result, while the shielding plate 5 of the first circuit board 21 and the second housing 12 are connected and fixed, the first circuit board 21 can also be grounded to avoid signal interference.

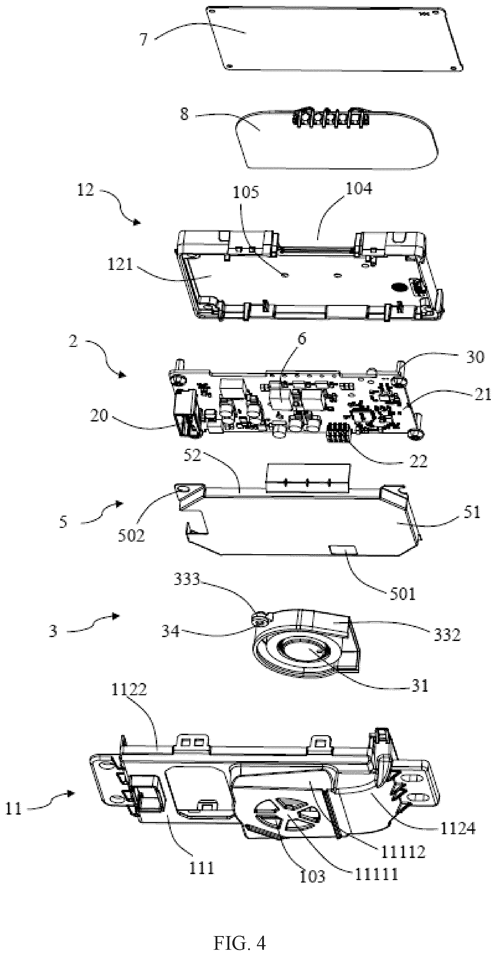

Referring to FIG. 3 and FIG. 4, a plurality of heat sinks 6 are provided between the first circuit board 21 and the shielding plate 5. Specifically, the plurality of heat sinks 6 are provided at the bottom of the first circuit board 21. One ends of the plurality of heat sinks 6 are respectively connected to the bottom of the first circuit board 21, and another ends of the plurality of heat sinks 6 are respectively connected to the bottom plate 51 of the shielding plate 5. As a result, part of the heat emitted by the first circuit board 21 can be absorbed by the shielding plate 5, thereby improving the heat dissipation performance of the first circuit board 21.

Referring to FIG. 3 and FIG. 4, the wireless charging device 100 further includes a shielding circuit board 7 and a power transmitting coil 8. Specifically, a recessed portion 1211 is provided on a side of the second housing 12 away from the receiving cavity 101, and the power transmitting coil 8 is disposed in the recessed portion 1211. The shielding circuit board 7 covers the power transmitting coil 8. Specifically, the recessed portion 1211 is provided on the first top wall 121. A groove 104 is formed at an edge of the second side wall 122. At least part of the wires of the power transmitting coil 8 pass through the groove 104 and are electrically connected to the first circuit board 21. The shielding circuit board 7 is fixed to a top of the second housing 12 through screws so as to cover the recessed portion 1211. A plurality of metal wires are arranged inside the shielding circuit board 7. When the wireless charging device 100 is working, the shielding circuit board 7 can shield the electromagnetic interference signal generated by the power transmitting coil 8 so as to improve the grounding effect of the power transmitting coil 8. At the same time, the magnetic field required for wireless charging can pass through without affecting charging.

Referring to FIG. 3, some thermally conductive glue 9 is disposed between the first circuit board 21 and the second housing 12. Specifically, the thermally conductive glue 9 is disposed on a top of the first circuit board 21. One end of the thermally conductive glue 9 is connected to the top of the first circuit board 21, and the other end of the thermally conductive glue 9 passes through a second through hole 105 of the second housing 12 and is in contact with the power transmitting coil 8. The first circuit board 21 is provided with a temperature sensor which monitors the temperature generated by the power transmitting coil 8 in real time through the thermally conductive glue 9, so that the rotation speed of the fan 31 according to the monitored temperature can be controlled by the first circuit board 21. By using the thermally conductive glue 9 to monitor the temperature of the power transmitting coil 8 in real time, it is simple and convenient and saves internal space. In this embodiment, the first circuit board 21 defines a plurality of dispensing holes. The thermally conductive glue 9 of the second housing 12 enters by a dispensing machine from the bottom of the first circuit board 21 through the dispensing holes, until the thermal conductive glue 9 passes through the second through hole 105 of the second housing 12 and contacts the power transmitting coil 8, then the dispensing machine completes the dispensing process of thermally conductive glue 9, and the manufacturing process is simple and fast, and the cost is low.

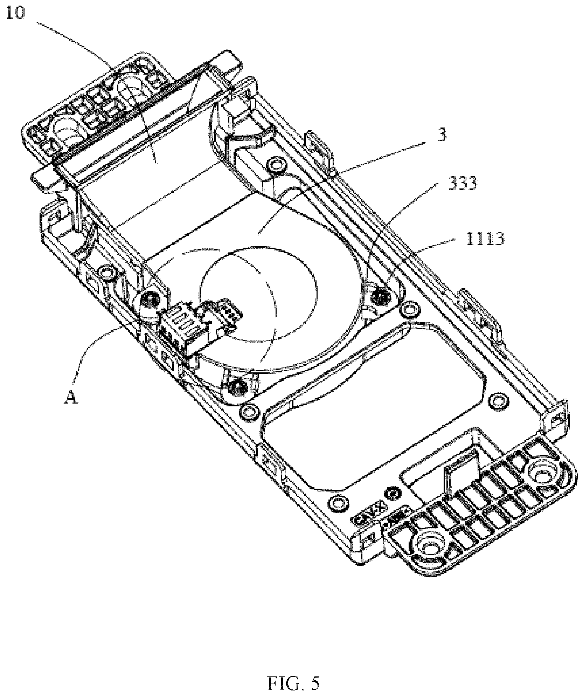

Referring to FIG. 3 and FIG. 5, the wireless charging device 100 further includes an air duct 10 provided in the first housing 11. An air inlet of the air duct 10 is arranged corresponding to the fan module 3. An air outlet of the air duct 10 is located next to the shielding circuit board 7. The air duct 10 has an L-shaped structure. The entire air duct 10 is provided on an inner wall surface attached to the first side wall 112. Specifically, the first side wall 112 includes a first sub-side wall 1122 and a second sub-side wall 1123 which are disposed oppositely along the second direction D2-D2, and a third sub-side wall 1124 and a fourth sub-side wall 1125 which are disposed oppositely along the third direction D3-D3. The second side wall 122 includes a fifth sub-side wall 1222 and a sixth sub-side wall 1223 which are disposed oppositely along the second direction D2-D2, and a seventh sub-side wall 1224 and a eighth sub-side wall 1225 which are disposed oppositely along the third direction D3-D3. When the first housing 11 and the second housing 12 are snap-fitted and connected, the first sub-side wall 1122 is connected to the fifth sub-side wall 1222, the second sub-side wall 1123 is connected to the sixth sub-side wall 1223, the third sub-side wall 1124 is connected to the seventh sub-side wall 1224, and the fourth sub-side wall 1125 is connected to the eighth sub-side wall 1225. The protruding portion 1111 is disposed adjacent to the third sub-side wall 1124. The air duct 10 is provided on an inner wall surface of the third sub-side wall 1124. The air outlet of the air duct 10 is provided between the third sub-side wall 1124 and the seventh sub-side wall 1224. Specifically, the notch 302 of the annular portion 332 of the fan housing 33 is disposed toward the inner wall surface of the third sub-side wall 1124. The air inlet of the air duct 10 is connected to the annular portion 332 so that the notch 302 is connected with the air inlet of the air duct 10. When the fan 31 is turned on, the cold air can enter the annular portion 332 from the air inlet holes 103 under the drive of the fan 31, and then blow to a side of the shielding circuit board 7 through the air duct 10. In this way, an electronic product that is being charged on the shielding circuit board 7 can be cooled down, thereby preventing the electronic product from becoming too hot during charging and reducing its service life.

Referring to FIG. 2, the present invention also discloses a vehicle having the wireless charging device 100. The first circuit board 21 is further provided with a third connector 20. A control module of the vehicle is electrically connected to the third connector 20 so as to provide power and signal control to the first circuit board 21. The wireless charging device 100 in the present embodiment is suitable for fuel vehicles, new energy vehicles, etc., which is not limited here. By providing the wireless charging device 100 disclosed in the present invention, the noise in a vehicle cabin can be reduced, thereby improving the driving experience.

In summary, the present invention discloses the wireless charging device 100. The wireless charging device 100 includes the housing 1, the wireless charging module 2 and the fan module 3. The housing 1 defines the receiving cavity 101. The wireless charging module 2 is disposed in the receiving cavity 101. The wireless charging module 2 includes the first circuit board 21 and the first connector 22 provided on the first circuit board 21. The fan module 3 is disposed in the receiving cavity 101. The fan module 3 includes the fan 31 and the second circuit board 32 disposed on the fan 31. Through the elastic contact between the first connector 22 and the second circuit board 32, the vibration generated by the fan 31 when it is turned on can be reduced, thereby reducing the noise.

The above embodiments are only used to illustrate the present invention and not intended to limit the present invention as defined in the appended claims.

## Claims

1. A wireless charging device (100), **characterized by** comprising:
a housing (1) defining a receiving cavity (101);
a wireless charging module (2) disposed in the receiving cavity (101), the wireless charging module (2) comprising a first circuit board (21) and a first connector (22) provided on the first circuit board (21); and
a fan module (3) disposed in the receiving cavity (101), the fan module (3) comprising a fan (31) and a second circuit board (32) provided on the fan (31); the first connector (22) is in elastic contact with the second circuit board (32).

2. The wireless charging device (100) as claimed in claim 1, wherein the first connector (22) comprises an insulating body (221) and a plurality of conductive terminals (222) fixed to the insulating body (221); the conductive terminal (222) comprises a fixing portion (2221) and a cantilever portion (2222) extending and bent from the fixing portion (2221); the cantilever portion (2222) protrudes beyond the insulating body (221); the fan module (3) comprises a conductive portion (321) connected to the second circuit board (32); the cantilever portion (2222) of the conductive terminal (222) is in elastic contact with the conductive portion (321).

3. The wireless charging device (100) as claimed in claim 2, wherein the insulating body (221) defines a plurality of receiving slots (201) and a plurality of step portions (2211) corresponding to the plurality of receiving slots (201); corresponding to each receiving slot (201), two step portions (2211) are provided and extend into the receiving slot (201); the cantilever portion (2222) comprises a blocking portion (22221) abutting against the two step portions (2211).

4. The wireless charging device (100) as claimed in claim 2 or 3, wherein the cantilever portion (2222) is provided with a protruding contact portion (22222) which is in surface-to-surface contact with the conductive portion (321).

5. The wireless charging device (100) as claimed in claim 2, 3 or 4, wherein the fan module (3) further comprises a fan housing (33) in which the second circuit board (32) is disposed; the fan housing (33) defines a through hole (301); the conductive portion (321) passes through the through hole (301) to be connected to the second circuit board (32).

6. The wireless charging device (100) as claimed in one of claims 1 to 5, wherein the housing (1) comprises a first housing (11) and a second housing (12); the first housing (11) and the second housing (12) are snap-fitted to form the receiving cavity (101); the fan (31) is fixed to an inner wall of the first housing (11); the first circuit board (21) is fixed to an inner wall of the second housing (12).

7. The wireless charging device (100) as claimed in claim 6, wherein an elastic member (4) is further provided between the fan (31) and the inner wall of the first housing (11).

8. The wireless charging device (100) as claimed in claim 6 or 7, further comprising a shielding plate (5) provided in the receiving cavity (101); the shielding plate (5) being disposed between the fan (31) and the first circuit board (21); the first connector (22) passing through the shielding plate (5) to be in elastic contact with the conductive portion (321) of the second circuit board (32).

9. The wireless charging device (100) as claimed in claim 6, 7 or 8, further comprising a shielding circuit board (7) and a power transmitting coil (8); a recessed portion (1211) being provided on a side of the second housing (12) away from the receiving cavity (101); the power transmitting coil (8) being disposed in the recessed portion (1211); the shielding circuit board (7) covering the power transmitting coil (8).

10. The wireless charging device (100) as claimed in claim 9, further comprising an air duct (10) provided in the first housing (11); an air inlet of the air duct (10) being arranged corresponding to the fan module (3), and an air outlet of the air duct (10) being located next to the shielding circuit board (7).

11. The wireless charging device (100) as claimed in one of claims 1 to 10, wherein the first circuit board (21) and the second circuit board (32) are detachably assembled together.

12. The wireless charging device (100) as claimed in one of claims 7 to 11, wherein the elastic member (4) is configured to absorb vibration generated by the fan (31), so that the vibration will not be directly transmitted to the first housing (11).

13. The wireless charging device (100) as claimed in one of claims 7 to 12, wherein the first housing (11) comprises a first bottom wall (111), the first bottom wall (111) is provided with a protruding portion (1111) protruding outward from the first bottom wall (111) toward a side away from the receiving cavity (101), the protruding portion (1111) comprises a second bottom wall (11111), the second bottom wall (11111) defines a plurality of air inlet holes (103), the fan (31) is disposed facing the plurality of air inlet holes (103), and the elastic member (4) is disposed around the plurality of air inlet holes (103).

14. The wireless charging device (100) as claimed in claim 13, wherein the second bottom wall (11111) is further provided with a reinforcing rib (1112) which is in a semi-ring shape, the reinforcing rib (1112) is disposed around the plurality of air inlet holes (103), the elastic member (4) is in a semi-ring shape, and the elastic member (4) and the reinforcing rib (1112) are arranged concentrically.

15. A vehicle, **characterized by** comprising:
a control module; and
a wireless charging device (100) as claimed in any one of claims 1 to 14;
wherein the first circuit board (21) is further provided with a third connector (20), and the control module of the vehicle is electrically connected to the third connector (20).
